# FASCICULE DE BREVET EUROPEEN

(11) **EP 0 883 134 B1**
(45) Date de publication et mention de la délivrance du brevet: **16.08.2000**
(21) Numéro de dépôt: 98401325.0
(22) Date de dépôt: 03.06.1998
(51) Int. Cl.: G11C 29/00

(54) **Circuit intégré à mémoire non volatile électriquement programmable avec registre de configuration d'options**
Integrierte elektrische programmierbare nichtflüchtige Speicheranordnung mit Konfigurationsregister
Electrically programmable non-volatile memory integrated circuit with options configuration register

(30) Priorité: 04.06.1997 FR 9706893
(43) Date de publication de la demande: 09.12.1998
(73) Titulaire: STMicroelectronics S.A., 94250 Gentilly (FR)
(72) Inventeur: Rochard, Laurent, 94230 Cachan (FR)
(74) Mandataire: Ballot, Paul

(56) Documents cités:
- EP-A- 0 420 388
- EP-A- 0 698 890
- US-A- 5 572 707

## Description

La présente invention concerne un circuit intégré à mémoire non-volatile électriquement programmable avec registre de configuration d'options. Elle s'applique notamment mais pas exclusivement dans le domaine des mémoires EPROM.

Un circuit intégré à mémoire offre généralement un certain nombre d'options à l'utilisateur. En fonction de son application, l'utilisateur va ainsi sélectionner telle ou telle option. Il peut par exemple choisir entre un oscillateur cristal ou un oscillateur en anneau (RC); ou choisir entre une fonction chien de garde matérielle ou logiciel; ou valider ou non une protection en lecture de tout ou partie du contenu de la mémoire; ou encore sélectionner un port d'entrée/sortie parmi plusieurs possibilités. Cette liste d'options n'est pas exhaustive, et de nombreuses autres options sont offertes en pratique. A chaque option doit alors correspondre un ou plusieurs bits de configuration. Ces bits sont contenus dans un registre de configuration d'options réalisé au moyen de cellules de la mémoire, agencées en éléments bistables.

En fin de fabrication du circuit intégré, ce dernier doit être testé de manière complète, dans toutes les configurations possibles, avant la fourniture à l'utilisateur.

Pour effectuer ce test, il faut donc, pour chaque configuration, venir programmer le registre de configuration d'options de manière appropriée.

S'agissant de cellules d'une mémoire programmable une seule fois (mémoire OTP), il n'est pas possible de procéder ainsi, par programmations successives de toutes les combinaisons possibles. Pour cette raison, on a associé des moyens de test aux éléments bistables à cellules mémoire, pour forcer l'état des bits de configuration sans programmer les cellules mémoire du registre. On peut ainsi tester les différentes options dans toutes les configurations possibles, sans toucher aux cellules mémoire.

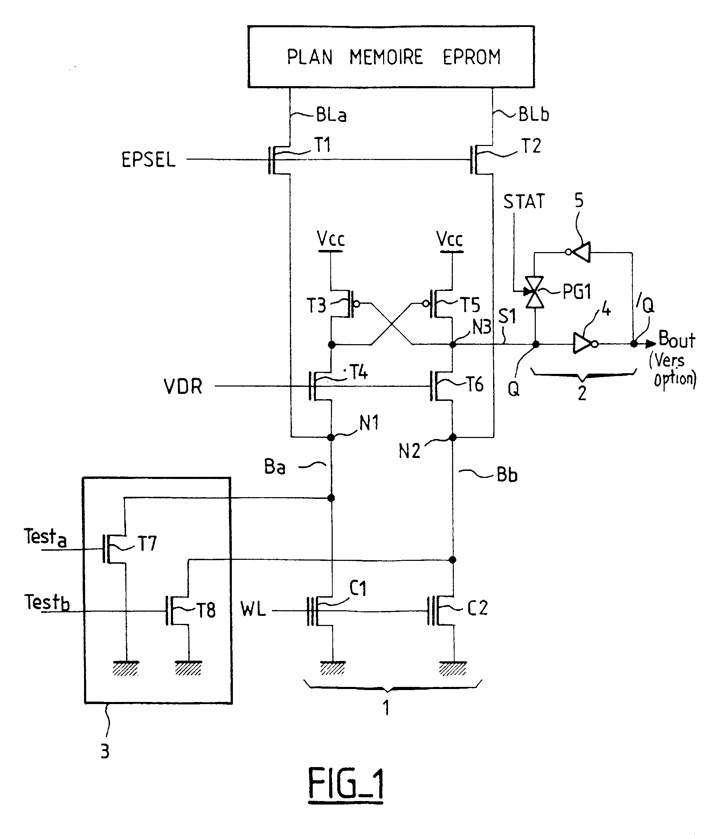

Un exemple de registre de configuration de ce type est représenté en figure 1. Dans cet exemple, la mémoire est du type EPROM, électriquement programmable, dont l'effacement par rayons ultra-violets est empêché par utilisation d'un boîtier plastique d'encapsulation sans fenêtre. On notera que d'autres types de mémoire programmable une seule fois existent, mais l'objet de l'invention n'est pas de les énumérer.

La mémoire (non représentée) est organisée de manière habituelle en lignes de bit (ou colonnes) et lignes de mot (ou rangées).

Un étage du registre de configuration correspondant à un bit comprend un étage bistable 1 suivi d'un étage de mémoire statique 2 à inverseurs.

L'étage bistable 1 comprend deux branches Ba et Bb. La première branche Ba est reliée à une ligne de bit BLa de la mémoire par un premier transistor T1. La deuxième branche Bb est reliée à une autre ligne de bit BLb par un deuxième transistor T2. Ces deux transistors, qui dans l'exemple sont de type N, sont commandés par un signal de sélection de l'étage bistable, noté EPSEL sur la figure.

Dans chaque branche, on a deux transistors et une cellule mémoire connectés en série entre la tension d'alimentation logique Vcc et la masse. Dans l'exemple, on a un transistor de type P dont la source est reliée à Vcc et un transistor de type N entre le transistor de type P et la cellule. La grille du transistor de type P d'une branche est connectée au drain du transistor de type N de l'autre branche. La grille du transistor de type N de chaque branche est commandée par un même signal de commande noté VDR, dont le niveau est fonction de l'opération à effectuer. Le transistor de sélection associé à une branche est connecté au point de connexion entre le transistor N et la cellule mémoire de cette branche (c'est à dire sur le drain de la cellule mémoire). Le transistor T1 est ainsi connecté au point de connexion N1 de la branche Ba et le transistor T2 est connecté au point de connexion N2 de la branche Bb.

Enfin, les cellules mémoire sont commandées sur leur grille par un signal de commande WL.

La sortie de l'étage bistable est prise sur l'une ou l'autre branche, au point de connexion des deux transistors (ie dans l'exemple, au drain d'un transistor N).

Dans la branche Ba, on trouve ainsi entre Vcc et la masse, un transistor de type P, T3, un transistor de type N, T4 et une cellule mémoire C1. Dans la branche Bb, on trouve de même un transistor de type P, T5, un transistor de type N, T6 et une cellule mémoire C2.

La sortie S1 de l'étage bistable 1 est prise au noeud N3 de la branche Bb, correspondant au drain du transistor T6.

Les deux cellules sont vierges en fin de fabrication. Si on applique une tension de lecture sur leur grille (signal WL) elles sont passantes et la sortie S1 est à zéro volt.

Si la cellule C1 est programmée, la cellule C2 restant vierge, la cellule C1 devient bloqué, mais la cellule C2 étant passante, la sortie S1 reste à zéro.

Si c'est la cellule C2 qui est programmée, la cellule C1 restant vierge, la sortie S1 va monter sensiblement à Vcc (en fait Vcc - Vtp, Vtp étant la tension de seuil de transistor P).

La programmation complémentaire des cellules mémoire C1 et C2 s'effectue en appliquant une haute tension de programmation généralement notée Vpp sur la ligne de bit associée à la cellule à programmer au moyen des transistors de commutation T1 et T2 et en portant à Vpp le signal de commande de grille WL des cellules (mémoire EPROM). Dans le même temps, le signal VDR de commande de grille des transistors N est mis à zéro, de manière à déconnecter les transistors P et N de chaque cellule, le temps de la programmation.

L'application de la haute tension sur la ligne de bit à programmer se fait de manière connue au moyen d'un commutateur de haute tension associé à un registre d'entrée de donnée à programmer et d'un décodeur d'adresse de lignes de bit.

Les moyens de test associés à cet étage bistable comprennent un étage de mémoire statique 2 et des moyens 3 pour forcer la sortie de l'étage bistable à un niveau déterminé, indépendamment des cellules mémoire.

L'étage de mémoire statique comprend de manière classique un premier inverseur 4 entre une borne Q et une borne \Q et un deuxième inverseur 5 entre la borne /Q et la borne Q. Dans l'exemple, la borne Q est connectée à la sortie S1 de l'étage bistable 1 et la borne /Q est utilisée comme borne de sortie Bout vers les options. Une porte de transfert PG1 est prévue entre la sortie du deuxième inverseur 5 et l'entrée Q du premier inverseur. Cette porte de transfert qui comprend classiquement un transistor P et un transistor N en parallèle, est commandée par un signal STAT.

En mode opérationnel, la porte de transfert PG1 est ouverte (circuit ouvert) et l'inverseur 4 suit le niveau de la sortie S1 de l'élément bistable à cellules mémoire, pour délivrer en sortie Bout un niveau complémentaire, vers une entrée de configuration d'une option du circuit intégré.

En mode de test (lecture et programmation) de l'élément de mémoire statique, la porte PG1 est rendue passante (fermée) pour mémoriser un état déterminé avec le deuxième inverseur.

Les moyens de test comprennent des moyens pour forcer le niveau de sortie S1 de l'élément bistable indépendamment des cellules mémoire. Ils consistent en un transistor placé en parallèle sur chaque cellule. On a ainsi le transistor de type N T7, en parallèle sur la cellule C1 et le transistor de type N T8, en parallèle sur la cellule C2. Ces transistors sont respectivement commandés sur leur grille par un signal testₐ et un signal test_{b}.

En test, ces deux signaux sont complémentaires l'un de l'autre, en sorte qu'un seul transistor est passant, l'autre étant bloqué. Pendant ce test, les deux cellules mémoire ont leur grille forcée à zéro par le signal WL, pour qu'elles soient bloquées. De cette manière on peut simuler les deux états possibles dans l'étage bistable, en rendant passant soit le transistor T7 de la branche Ba, soit le transistor T8 de la branche Bb. Dans l'élément de mémoire statique, la porte de transfert PG1 est rendue passante (court circuit) en sorte que le deuxième inverseur 5 vienne confirmer le niveau de S1.

En mode opérationnel, les deux signaux de testₐ et test_{b} sont forcés à zéro, pour bloquer les deux transistors T7 et T8.

Une telle structure se révèle peu efficace en pratique. En effet, pour chaque bit de configuration, il faut deux lignes de test testₐ et test_{b} avec un registre de test associé. Un registre de configuration comprenant habituellement plus de 8 bits, cela fait 16 lignes de test et deux registres 8 bits de test au minimum.

En outre, topologiquement, les cellules mémoire utilisées dans le registre de configuration sont situées en fin de lignes de bit alors que tous les registres sont regroupés en tête de lignes de bit.

La réalisation pratique de la structure est donc très gourmande en occupation de surface de circuit intégré. Cela conduit à une limitation nécessaire des lignes de test, à 4 par exemple pour tester les bits du registre de configuration. Il s'ensuit une sévère limitation de la couverture de test puisque l'on ne peut plus tester chaque bit et chaque option indépendamment des autres.

Dans l'invention, on a cherché à résoudre ce problème de test du registre de configuration et des options d'une autre manière qui permette une couverture de test complète.

On s'est rendu compte que les limitations de la structure de l'état de la technique étaient dues au fait que l'élément de mémoire statique était forcé au travers de l'élément bistable, ce qui obligeait à dupliquer en quelque sorte toutes les lignes de bit BLa-BLb associées au registre de configuration, pour avoir les lignes de test testₐ et test_{b} nécessaires.

Dans l'invention on a cherché un autre moyen pour forcer l'élément de mémoire statique, indépendamment de l'élément bistable à cellules mémoire.

Une solution a été trouvée à ce problème technique, qui permet d'utiliser les ressources de la mémoire pour accéder aux éléments de mémoire statique.

Telle que caractérisée, l'invention concerne donc un circuit intégré à mémoire non volatile électriquement programmable avec registre de configuration d'options, la mémoire comprenant des ressources de lecture/écriture connectées à une première et une deuxième ligne de bit, ledit registre comprenant pour chaque bit, un élément bistable à cellules de la mémoire, relié à la première et la deuxième ligne de bit, suivi d'un élément de mémoire statique.

Selon l'invention, des moyens sont prévus pour relier ledit élément de mémoire statique à la première et à la deuxième ligne de bit, de manière à lire ou forcer un état dudit élément de mémoire statique par ces lignes de bit et les ressources de lecture/écriture de la mémoire non volatile

Les caractéristiques et avantages de l'invention sont détaillés dans la description suivante, faite à titre indicatif et non limitatif, en référence aux dessins annexés, dans lesquels :
- la figure 1 déjà décrite représente la structure d'un étage du registre de configuration de l'état de la technique;
- la figure 2 représente une structure d'un étage du registre de configuration selon l'invention et
- la figure 3 représente un schéma-bloc général d'une mémoire avec registre de configuration selon l'invention.

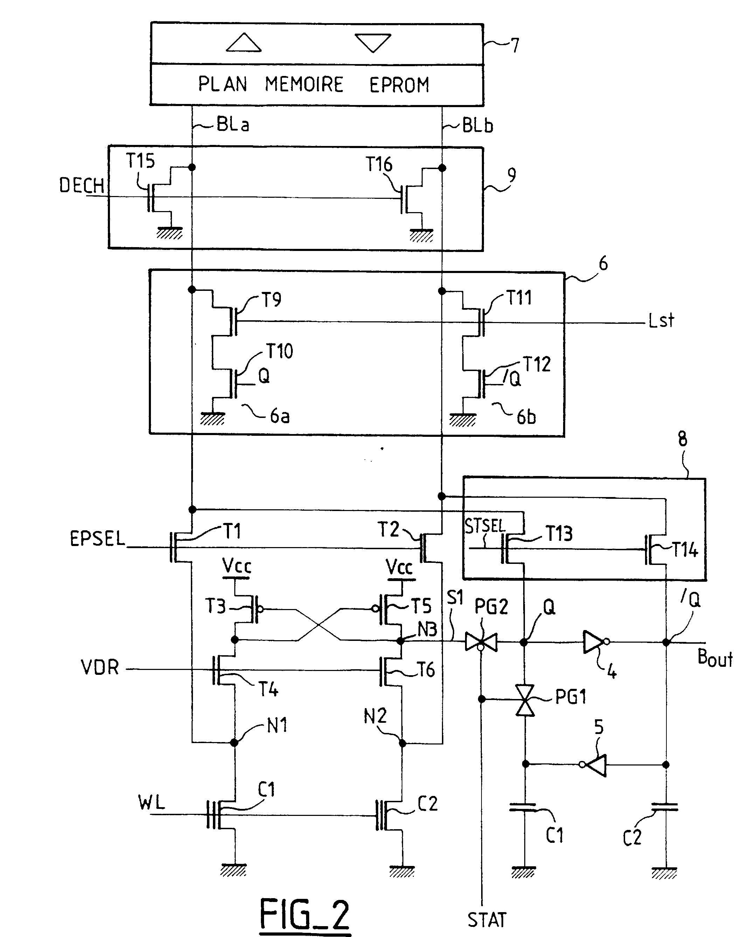

La figure 2 représente une structure d'un étage du registre de configuration selon l'invention. Les éléments communs à la figure 1 portent les mêmes références.

Le registre comprend comme précédemment un élément bistable 1 à cellules mémoire C1, C2 et un élément de mémoire statique 2 à inverseurs 4 et 5. Pour tester le registre de configuration et les options, il utilise les ressources de la mémoire, à savoir les lignes de bit et les circuits de lecture/écriture (comprenant notamment un commutateur haute tension Vpp) auxquels ces lignes sont reliées. Pour lire l'élément de mémoire statique, des moyens de lecture 6 sont prévus. Ils comprennent un circuit 6a associé à la borne Q de l'élément mémoire statique et un circuit 6b associé à la borne /Q.

Le circuit 6a comprend deux transistors T9 et T10 en série entre la ligne de bit BLa et la masse. Le transistor T9 relié à la ligne de bit est commandé sur sa grille par un signal de test de lecture LST. Le transistor T10 relié à la masse a sa grille connectée à la borne Q de l'élément de mémoire statique.

Le circuit 6b comprend deux transistors T11 et T12 en série entre la ligne de bit BLa et la masse.

Le transistor T11 relié à la ligne de bit est commandé sur sa grille par le signal de test de lecture LST. Le transistor T12 relié à la masse a sa grille connectée à la borne /Q de l'élément de mémoire statique. Dans l'exemple, les transistors T9 à T12 sont de type N.

Supposons que l'élément de mémoire statique ait été forcé à "1" sur sa borne Q. Si cet élément est sélectionné en test de lecture, on va avoir une tension de l'ordre de Vcc sur le transistor T10. Le signal de test de lecture LST est actif (à Vcc). Et la ligne de bit BLa elle même est sélectionnée en lecture (à Vcc).

Les transistors T9 et T10 sont alors passants. Un courant circule sur la ligne de bit BLa. Ce courant va être détecté par le circuit amplificateur 7 de la mémoire, activé en lecture. Ce circuit va délivrer en sortie un état binaire correspondant (1 par exemple) de la mémoire.

Si on effectue la lecture sur la ligne de bit BLb, le transistor T12 lui est bloqué puisqu'il est connecté à la borne /Q forcée à zéro. Aucun courant ne circule sur cette ligne de bit et l'amplificateur 7 délivre un état binaire correspondant (0 dans l'exemple), complémentaire de celui lu sur la ligne BLa.

Tout le temps de cette lecture, les transistors T1 et T2 qui relient les lignes de bits BLa et BLb aux cellules mémoire C1 et C2 de l'élément bistable sont bloqués (EPSEL = 0).

Pour forcer l'élément de mémoire statique, des moyens d'écriture 8 sont prévus. Ils comprennent un transistor T13 connecté entre la ligne de bit BLa et la borne Q et un transistor T14 connecté entre la ligne de bit BLb et la borne /Q.

Ces deux transistors sont commandés sur leur grille par un signal de sélection d'écriture de l'élément de mémoire statique, noté STSEL. Dans l'exemple les deux transistors T13 et T14 sont de type N.

Si on veut forcer Q à 0 et /Q à 1, on applique en entrée du circuit 7 activé en écriture (commutateur haute tension) une donnée d'entrée correspondante pour positionner la ligne de bit BLb à 1. La ligne de bit BLa est en haute impédance comme toutes les autres lignes de bit.

En activant STSEL (=Vcc) les transistors T13 et T14 deviennent passants. Le transistor T14 commute le niveau de tension de ligne (au maximum un niveau Vcc, puisque sa grille est à Vcc) sur la borne /Q correspondante. La borne Q va automatiquement suivre à zéro. Quand STSEL est désactivé, l'élément de mémoire statique conserve le même état (c'est à dire dans l'exemple, Q=0 et /Q=1). Si on veut forcer Q à 1 et /Q à 0 , c'est la ligne BLb qui sera en haute impédance et la ligne BLa sera positionnée à 1.

On notera que normalement la ligne de bit positionnée à 1 est portée en pratique à une haute tension (de l'ordre de V) par le commutateur de haute tension du circuit 7.

En test on n'a cependant pas besoin d'un tel niveau pour l'élément de mémoire statique. Dans le cas où la haute tension Vpp est fournie sur un plot d'entrée du circuit mémoire, une tension de l'ordre de Vcc est suffisante à appliquer pour le test.

Quand on est en phase d'écriture, le circuit 6 de lecture est désactivé (LST = 0). Quand on est en phase de lecture, le circuit 8 d'écriture est désactivé (STSEL = 0). Dans les deux cas, les transistors T1 et T2 sont maintenus bloqués.

En outre des portes de transfert PG1 et PG2 sont prévues, pour soit permettre au premier inverseur 4 de suivre le niveau de sortie S1 de l'élément bistable soit forcer un état dans l'élément mémoire statique.

Ces deux portes de transfert sont ainsi commandées de manière complémentaire, PG1 par le signal STAT, PG2 par l'inverse du signal STAT (noté sur la figure 2 par un petit rond sur PG2).

La porte PG1 est montée comme dans la figure 1. La porte PG2 est connectée entre la sortie S1 et la borne Q.

Avantageusement, pour ne pas avoir des perturbations de l'opération d'écriture, on prévoit des moyens 9 pour décharger les lignes de bit avant leur connexion aux bornes Q et /Q des éléments de mémoire statique.

En effet, une ligne de bit peut être chargée, du fait d'opérations précédentes.

Cette ligne pourrait rester chargée au lieu de passer en haute impédance. Si on la connecte ainsi à une borne Q et /Q de l'élément statique, on risque alors d'en altérer le contenu final.

Pour cette raison, on prévoit un transistor de décharge pour chaque ligne de bit, pour décharger cette ligne avant toute opération d'écriture.

Sur la figure 2, on a ainsi un transistor T15 connecté entre la ligne de bit BLa et la masse et un transistor T16 connecté entre la ligne de bit BLb et la masse. Dans l'exemple, ils sont de type N. Ils sont commandés sur leur grille par un signal de commande de décharge, noté DECH.

Pour améliorer le chargement du contenu de l'élément de mémoire statique, on peut aussi prévoir un condensateur C1, C2 connecté entre chaque borne Q, /Q et la masse. En effet, ces condensateurs permettent de compenser les capacités parasites des lignes de bit.

La structure de l'invention décrite en relation avec la figure 2 permet d'effectuer un test très complet du registre de configuration.

Elle permet en effet de forcer l'élément mémoire statique associé à chaque bit d'option pour configurer l'option associée et tester cette option dans cette configuration.

Elle permet aussi de vérifier directement le contenu de cet élément mémoire statique.

Enfin elle permet l'écriture des éléments bistables à cellules mémoire et leur lecture.

Toutes ces opérations sur les éléments de mémoire statique et sur les éléments bistables utilisent les mêmes ressources de lecture/écriture de la mémoire du circuit intégré.

Cette structure a donc un encombrement réduit et permet une couverture de test très complète, sans limiter les performances du circuit intégré. Notamment, aucun transistor n'a été rajouté sur le chemin de la programmation des cellules mémoire. Ainsi, la haute tension de programmation est transmise sans pertes supplémentaires (qui seraient dues à la structure du test).

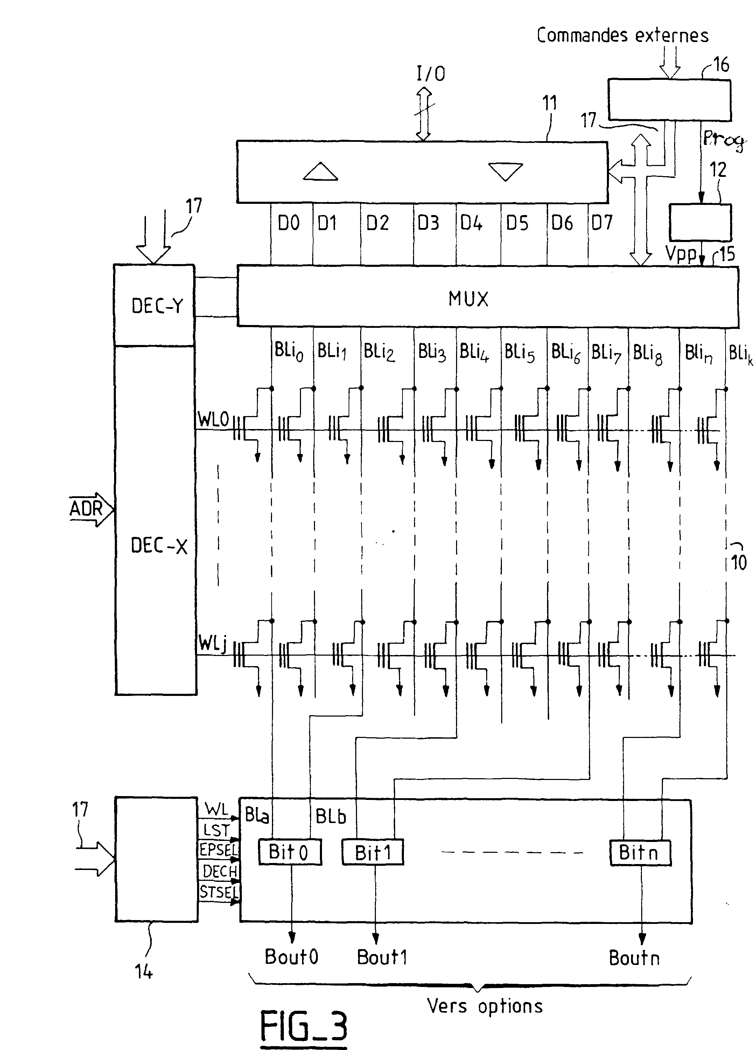

La figure 3 représente un schéma plus général d'un circuit intégré avec mémoire et registre de configuration selon l'invention.

On a ainsi représenté de manière classique un plan mémoire 10 avec ses cellules organisées en lignes de bit et lignes de mot, le décodeur de lignes de bit DEC-Y et le décodeur de lignes de mot DEC-X, un circuit porte 15 pour appliquer les tensions de polarisation appropriées sur les lignes de bit sélectionnées et les relier en entrée ou en sortie au circuit d'amplificateur de lecture/écriture 11. Un commutateur de haute tension 12 fournit la tension de programmation Vpp au circuit porte 15.

Un circuit de contrôle 16 (microcontrôleur) fournit en sortie 17 les différents signaux de commande nécessaires en fonction de commandes externes qu'il reçoit. Tous ces éléments se retrouvent dans les différentes architectures mémoire bien connues.

Le registre de configuration 13 est contrôlé par un circuit logique 14 associé commandé par le circuit de contrôle. En mode opérationnel, le registre de configuration est ainsi activé pour fournir le ou les bits de configuration nécessaires au traitement d'une commande. En mode de test, le circuit logique fournit la séquence des signaux correspondant aux différentes phases de test (test des options, test des éléments de mémoire statiques, test de programmation des cellules des éléments bistables).

Chaque bit du registre de configuration est relié à deux lignes de bits différentes du plan mémoire. Le choix des lignes de bit utilisées dépend principalement de la topologie du circuit et des facilités de décodage.

Dans l'exemple, le bit 0 est relié aux lignes BLi0 et BLi2 du plan mémoire et le bit 1 est relié aux lignes BLi4 et BLi7.

La sortie Bout0, Bout1 de chaque bit du registre de configuration est appliquée en entrée de configuration d'une option correspondante.

Les lignes de bit de la mémoire permettent en pratique de réaliser un registre de configuration très large en plusieurs mots (2x16 bits par exemple ou plus selon les besoins).

L'invention qui vient d'être décrite s'applique tout particulièrement, comme on l'a vu, aux mémoires électriquement programmables une seule fois. Mais elle s'applique aussi bien à toutes les mémoires non volatiles électriquement programmables en général. Notamment, elle s'applique aux mémoires EPROM avec fenêtre d'effacement ou sans fenêtre (OTP), la caractéristique effaçable/non effaçable n'étant dans ce cas qu'une caractéristique du boîtier et non de l'électronique interne.

## Revendications

1. Circuit intégré à mémoire non volatile électriquement programmable avec registre de configuration d'options, la mémoire comprenant des ressources (7) de lecture/écriture connectées à une première et deuxième ligne de bit (BLa, BLb), ledit registre comprenant pour chaque bit, un élément bistable (1) à cellules de la mémoire, relié à la première (BLa) et la deuxième ligne de bit (BLb), suivi d'un élément de mémoire statique (2), caractérisé en ce qu'il comprend des moyens (6,8) pour relier ledit élément de mémoire statique à la première et à la deuxième ligne de bit, de manière à lire ou forcer un état dudit élément de mémoire statique par ces lignes de bit et les ressources de lecture/écriture de la mémoire non volatile.

2. Circuit intégré selon la revendication 1, caractérisé en ce que les moyens pour relier comprennent un premier transistor (T9) et une deuxième transistor (T10) connectés en série entre chaque ligne de bit et la masse, le premier transistor (T9, T11) relié à une ligne de bit étant commandé par un signal de commande de lecture (LST) dudit élément de mémoire statique, le deuxième transistor (T10) relié à la première ligne de bit (BLa) étant commandé par une première borne (Q) dudit élément de mémoire statique et le deuxième transistor (T12) relié à la deuxième ligne de bit (BLb) étant commandé par une deuxième borne (/Q) dudit élément de mémoire statique.

3. Circuit intégré selon la revendication 1 ou 2, caractérisé en ce que les moyens pour relier (8) comprennent un premier transistor (T13) connecté entre la première ligne de bit (BLa) et la première borne (Q) de l'élément de mémoire statique et un deuxième transistor (T14) connecté entre la deuxième ligne de bit (BLb) et la deuxième borne (/Q) de l'élément de mémoire statique, ces deux transistors étant commandés par un signal de commande d'écriture (STSEL) dudit élément de mémoire statique.

4. Circuit intégré selon la revendication 3, caractérisé en ce que les moyens pour relier comprennent en outre des moyens de décharge (9) des lignes de bit.

5. Circuit intégré selon les revendications 3 ou 4 caractérisé en ce qu'il comprend un condensateur entre chaque borne de l'élément de mémoire statique et la masse.

## Patentansprüche

1. Integrierte elektrisch programmierte nicht-flüchtige Speicheranordnung mit Konfigurationsregister, wobei die Speicheranordnung Einrichtungen (7) zum Lesen/-Schreiben aufweist, die mit einer ersten und einer zweiten Bitleitung (BLa, BLb) verbunden sind, wobei das Register für jedes Bit ein bistabiles Zellenelement (1) der Speicheranordnung aufweist, das mit der ersten (BLa) und der zweiten (BLb) Bitleitung verbunden ist, gefolgt von einem statischen Speicherelement (2), dadurch gekennzeichnet, daß sie Einrichtungen (6, 8) aufweist, um das statische Speicherelement mit der ersten und zweiten Bitleitung zu verbinden, derart, daß sie einen Zustand des statischen Speicherelements durch diese Bitleitungen und die Lese/Schreib-Einrichtungen des nicht-flüchtigen Speichers liest oder erzwingt.

2. Integrierte Speicheranordnung nach Anspruch 1, dadurch gekennzeichnet, daß die Verbindungseinrichtungen einen ersten Transistor (T9) und einen zweiten Transistor (T10) aufweisen, die in Serie zwischen jeder Bitleitung und der Masse verbunden sind, wobei der erste Transistor (T9, T11) mit einer Bitleitung verbunden ist, die durch ein Lesesteuersignal (LST) des statischen Speicherelements gesteuert wird, wobei der zweite Transistor (T10), der mit der ersten Bitleitung (BLa) verbunden ist, durch einen ersten Anschluß (Q) des statischen Speicherelements gesteuert wird und der zweite Transistor (T12), der mit der zweiten Bitleitung (BLb) verbunden ist, durch einen zweiten Anschluß (/Q) des statischen Speicherelements gesteuert wird.

3. Integrierte Speicheranordnung nach Anspruch 1 oder 2, dadurch gekennzeichnet, daß die Verbindungseinrichtungen (8) einen ersten Transistor (T13) aufweisen, der zwischen der ersten Bitlinie (BLa) und dem ersten Anschluß (Q) des statischen Speicherelements geschaltet ist, und einen zweiten Transistor (T14) aufweist, der zwischen der zweiten Bitleitung (BLb) und dem zweiten Anschluß (/Q) des statischen Speicherelements geschaltet ist, wobei die beiden Transistoren durch ein Lesesteuersignal (STSEL) des statischen Speicherelements gesteuert werden.

4. Integrierte Speicheranordnung nach Anspruch 3, dadurch gekennzeichnet, daß die Verbindungseinrichtungen darüber hinaus Entladungseinrichtungen (9) der Bitleitungen aufweisen.

5. Integrierte Speicheranordnung nach Anspruch 3 oder 4, dadurch gekennzeichnet, daß sie einen Kondensator zwischen einem jeden Anschluß des statischen Speicherelements und der Masse aufweist.

## Claims

1. Integrated circuit with an electrically programmable non-volatile memory with an option configuration register, the memory comprising read/write resources (7) connected to first and second bit lines (BLa, BLb), the said register comprising, for each bit, a bistable element (1) with cells of the memory, connected to the first (BLa) and second (BLb) bit lines, followed by a static memory element (2), characterised in that it comprises means (6, 8) for connecting the said static memory element to the first and second bit lines, so as to read or force a state of the said static memory element by these bit lines and the read/write resources of the non-volatile memory.

2. Integrated circuit according to Claim 1, characterised in that the means for connecting comprise a first transistor (T9) and a second transistor (T10) both connected in series between each bit line and earth, the first transistor (T9, T11) connected to a bit line being controlled by a read control signal (LST) for the said static memory element, the second transistor (T10) connected to the first bit line (BLa) being controlled by a first terminal (Q) of the said static memory element and the second transistor (T12) connected to the second bit line (BLb) being controlled by a second terminal (/Q) of the said static memory element.

3. Integrated circuit according to Claim 1 or 2, characterised in that the means for connecting (8) comprise a first transistor (T13) connected between the first bit line (BLa) and the first terminal (Q) of the static memory element and a second transistor (T14) connected between the second bit line (BLb) and the second terminal (/Q) of the static memory element, these two transistors being controlled by a write control signal (STSEL) for the said static memory element.

4. Integrated circuit according to Claim 3, characterised in that the means for connecting also comprise means (9) of discharging the bit lines.

5. Integrated circuit according to Claims 3 or 4, characterised in that it comprises a capacitor between each terminal of the static memory element and earth.
